# EUROPÄISCHE PATENTSCHRIFT

(11) **EP 1 470 586 B1**
(45) Veröffentlichungstag und Bekanntmachung des Hinweises auf die Patenterteilung: **15.01.2014**
(21) Anmeldenummer: 02796613.4
(22) Anmeldetag: 12.12.2002
(51) Int. Cl.: H01L 23/367, H01L 23/31, H01L 21/48

(54) **LEISTUNGS-HALBLEITER, UND VERFAHEN ZU SEINER HERSTELLUNG**
POWER SEMICONDUCTOR, AND METHOD FOR PRODUCING THE SAME
SEMI-CONDUCTEUR DE PUISSANCE ET LEUR PROCEDE DE PRODUCTION

(30) Priorität: 30.01.2002 DE 20201415 U
(43) Veröffentlichungstag der Anmeldung: 27.10.2004
(73) Patentinhaber: ebm-papst St. Georgen GmbH & Co. KG, 78112 St. Georgen (DE)
(72) Erfinder: HORNBERGER, Jörg, 72280 Dornstetten (DE); PFAFF, Andreas, 78141 Schönwald (DE)
(74) Vertreter: Raible, Tobias
(86) Internationale Anmeldenummer: PCT/EP2002/014107
(87) Internationale Veröffentlichungsnummer: WO 2003/065449

(56) Entgegenhaltungen:
- EP-A- 0 908 943
- US-A- 4 344 106
- US-A- 4 736 273
- US-A- 4 947 234
- US-A- 5 047 837
- US-B1- 6 320 258

## Beschreibung

Die Erfindung betrifft einen Leistungs-Halbleiter, und sie betrifft ein Verfahren zu seiner Herstellung.

Beim Aufbau von elektrischen Schaltungen werden sowohl bedrahtete als auch vermehrt Oberflächen-bestückbare Bauelemente (SMD bzw. surface mounted technology-Bauelemente) eingesetzt. Wegen des Trends zu immer kleinerer Bauweise werden Schaltungen bevorzugt in reiner SMD-Technik ausgelegt.

Bisher mussten Leistungs-Halbleiter nach der SMD-Bestückung einer Leiterplatte durch einen zusätzlichen Arbeitsschritt von Hand nachbestückt und, ebenfalls von Hand, auf die Leiterplatte aufgelötet werden. Der hierfür erforderliche Zeitbedarf verteuert die Produkte erheblich und führt zudem zu Qualitätsschwankungen und oft zusätzlichen Kosten für Nacharbeit.

Bei Schaltungen in SMD-Technik erfordern wegen der Anhäufung von Bauelementen thermische Aspekte eine erhöhte Aufmerksamkeit. Wird die thermische Energie nicht in ausreichender Menge abgeführt, so kann es auf einer mit SMD-Bauelementen bestückten Leiterplatte zu einem Wärmestau kommen. Als Folge hiervon können die verwendeten Bauelemente unerwünscht schnell degradieren, was u.U. zum Ausfall der Schaltung, dem sogenannten Hitzetod, führen kann.

Bei sehr hohen Leistungsdichten, z.B. im Personal-Computer-Bereich, ist es bekannt, entsprechende Lüfter einzusetzen, die eine Zwangskonvektion, also eine Wärmeabfuhr durch die Luft, gewährleisten. Ein anderer Lösungsweg ist die Verwendung von massiven Kühlblechen an Wärme entwickelnden Bauteilen, um die freie Konvektion zu verbessern. Auf der anderen Seite ist bei sehr kleinen Schaltungen, die wenig Leistung umsetzen, eine aktive Kühlung oft nicht erforderlich, so dass die Wärmeableitung über entsprechende wärmeleitfähige Materialien zur Vermeidung eines Wärmestaus ausreicht. Bei Leistungen in mittleren Bereichen von einigen Zehntel Watt werden thermische Probleme jedoch vielfach vernachlässigt, so dass hier vermehrt thermisch bedingte Ausfälle durch Hitzetod zu vermeiden sind. Dies trifft insbesondere auf reine SMD-Schaltungen zu, da dort die Verwendung von Kühlkörpern, welche von der Leiterplatte weg ragen, wegen der angestrebten Kompaktheit der Schaltungen meist nicht möglich ist.

Aus der US 6 320 258 B1 kennt man eine Anordnung mit einem IC, der für hohe Spannungen geeignet ist, z.B. für eine Wechselspannung von 2.800 V. Deshalb ist der IC vollständig in Kunststoff gekapselt, und seine Anschlüsse haben den von der Norm geforderten Luftabstand von 4,2 mm und einen Griechabstand von 5 mm. Der Halbleiter liegt auf einem Kühlkörper auf. Seine Anschlüsse sind gebogen, damit man die von der Norm geforderten Abstände von 4,2 bzw. 5 mm erhält.

Für das Problem der Befestigung eines Leistung-Halbleiters auf einem Trägerteil konnte dieser Schrift entnommen werden, dass man den Halbleiter mit einer Seite auf einen Kühlkörper schraubt, und dass sich die Anschlüsse parallel zu diesem Kühlkörper erstrecken sollen. Mit einer solchen Anordnung wäre jedoch eine SMD-Bestückung völlig ausgeschlossen.

Die US 5 047 837 betrifft einen IC, bei dem der eigentliche Halbleiterchip auf einem chip pad montiert ist, der zur Wärmeableitung dient und deshalb Wärmeableitfüße hat, die an einer Leiterplatte genauso angelötet werden wie die gestanzten Anschlussleiter des IC.

Auf diese Wärmeableitfüße wird ein spezieller Kühlkörper gelötet, um die Wärme aus dem chip pad zu diesem Kühlkörper zu leiten, der sie an die Umgebungsluft weitergibt. Die Zeichnung dieser Patentschrift zeigt ein Beispiel für diese Verbindung, und andere Figuren der Zeichnung zeigen verschiedene Formen von Kühlkörpern. Ein Diagramm zeigt im Vergleich die Wirksamkeit der verschiedenen Kühlkörper.

Aus dieser Schrift entnimmt man, dass man einen Kühlkörper, der einen IC trägt und dessen Wärme aufnimmt, über Wärmeableitfüße mit einer Leiterplatte verbindet, um Wärme aus dem IC zu dieser Leiterplatte abzuleiten, und dass man mit diesen Füßen einen Kühlkörper wärmeleitend verbindet, der sich wie ein Dach über den IC erstreckt. Wegen dieses separaten Kühlkörpers erscheint eine Befestigung im SMD-Verfahren ausgeschlossen, da dieser separate Kühlkörper an Wärmeableitfüßen fest angelötet ist und sich diese Lötverbindung im Lötbad lösen würde.

Es ist eine Aufgabe der vorliegenden Erfindung, einen neuen Leistungs-Halbleiter und ein neues Verfahren zur Herstellung eines solchen bereit zu stellen, der sich für die Bestückung im SMD-Verfahren eignet.

Diese Aufgabe wird gelöst durch einen Leistungs-Halbleiter nach Anspruch 1. Hierbei werden die Kontaktelemente leicht über die Fluchtungsebene der Unterseite des Halbleiterelements hinaus vom Kühlelement weg in Richtung zur Leiterplatte gebogen. Dies hat zum einen den Vorteil, dass Maßtoleranzen, insbesondere Fertigungs-, Bauteil-und Biegetoleranzen, beim Bestücken der Leiterplatte mit den Leistungs-Halbleitern besser ausgeglichen werden können. Zum anderen wird dadurch erreicht, dass der Leistungs-Halbleiter im montierten Zustand nicht mit seiner gesamten Unterseite auf der Leiterplatte aufliegen muss. Mit anderen Worten kann man erreichen, dass im montierten Zustand ein Luftspalt mindestens bereichsweise zwischen der Leiterplatte und der Unterseite des Leistungs-Halbleiters verläuft. Dieser Luftspalt dient dann als Wärmeisolator und reduziert wirkungsvoll den Wärmefluss vom Leistungs-Halbleiter zur Leiterplatte. Ein solcher Leistungs-Halbleiter zeichnet sich zudem durch kleine Abmessungen aus.

Eine solche Ausgestaltung ermöglicht in sehr vorteilhafter Weise die Bestückung einer Leiterplatte mit Leistungs-Halbleitern in SMD-Technik, und durch sie kann vermieden werden, dass solche Leistungs-Halbleiter mit ihrer Kühlfläche in großflächigen Kontakt zur Leiterplatte gelangen. Ein großflächiges Aufliegen der Kühlfläche auf der Leiterplatte, wie es im Stand der Technik durch eine bestimmte Geometrie der Kontaktfüße vorkommen konnte und dort zu einer starken Aufheizung der Leiterplatte führte, ist damit weitgehend ausgeschlossen.

Eine Übertragung der über das Kühlelement abgegebenen Wärme auf die Leiterplatte und die umliegenden elektronischen Bauelemente wird somit wirksam reduziert oder sogar ganz vermieden. Dadurch wird die Gefahr einer Überhitzung oder Beschädigung der Leiterplatte und der umliegenden Bauelemente stark verringert. Gleichzeitig gewährleistet das frei angeordnete Kühlelement eine ungehinderte Abgabe der Wärme an die Umgebung, z.B. durch natürliche Konvektion. Damit wird oft eine ausreichende Kühlung eines solchen Leistungs-Halbleiters erreicht. Insgesamt führt das zu einer Verlängerung der Lebensdauer, nicht nur des verwendeten Leistungs-Halbleiters, sondern auch der Leiterplatte und der auf ihr angeordneten Bauelemente. Da zudem meist keine massiven Kühlbleche oder Kühlkörper benötigt werden, bleibt die Anordnung kompakt.

Ein Leistungs-Halbleiter hat wenigstens ein Kontaktelement. Als besonders vorteilhaft hat sich dabei eine stufenförmige Geometrie der Kontaktelemente erwiesen. Dabei sind diese in Richtung Unterseite des Leistungs-Halbleiters, also beim montierten Halbleiter in Richtung Leiterplatte, absatzförmig abgebogen. Das Kontaktelement umfasst dabei bevorzugt einen vom Gehäuse des Leistungs-Halbleiters ausgehenden ersten Abschnitt, der über ein erstes Bogenstück in ein in Richtung Unterseite des Leistungs-Halbleiters abfallendes Schrägstück übergeht und anschließend über ein zweites Bogenstück in einem geraden Auslaufstück endet. Dabei verläuft das gerade Auslaufstück vorzugsweise parallel zum ersten Abschnitt. Durch bogenförmige Übergangsbereiche werden scharfkantige Übergänge, welche Risse und Brüche beim Biegen der Kontaktelemente hervorrufen könnten, vermieden.

Gemäß Anspruch 1 wird die Kühlung des Leistungs-Halbleiters weiter verbessert, indem eine Wärmeleitmatte oder dergleichen verwendet wird. Dies ist besonders in den Fällen sinnvoll, in denen die natürliche Konvektion nicht ausreicht, um die vom Leistungs-Halbleiter erzeugte Wärme abzuführen. Dies ist besonders dann von Vorteil, wenn die vom Leistungs-Halbleiter abgegebene Wärme an ein angrenzendes Gehäuse, beispielsweise ein Rechnergehäuse oder an eine angrenzende Kühlvorrichtung, beispielsweise Kühlbleche, Kühlrippen etc. weitergegeben werden soll. Die Wärmeleitmatte ist bevorzugt so bemessen, dass sie gut auf dem Kühlelement aufliegt, um einen größtmöglichen Wärmefluss zu gewährleisten. Durch den Einsatz der Wärmeleitmatte wird eine bessere Kühlung erreicht, was wiederum die Dauerleistung und Lebensdauer des Leistungs-Halbleiters sowie der benachbarten Bauelemente erhöht. Darüber hinaus ermöglicht die Wärmeleitmatte den Ausgleich von Maßtoleranzen, insbesondere von Fertigungs-, Bauteil- oder Löttoleranzen.

Die natürliche Konvektion auf beiden Seiten einer Leiterplatte kann genutzt werden, wenn in bevorzugter Weise die Leistungs-Halbleiter in einer Sandwich-Bauweise an gegenüberliegenden Seiten der Leiterplatte angeordnet sind.

Eine andere Lösung der gestellten Aufgabe ergibt sich durch den Gegenstand des Anspruchs 9. Dadurch, dass die Kontaktelemente so gebogen werden, dass sie die genannte Fluchtungsebene durchdringen, ergibt sich eine kompakte Bauweise und gleichzeitig eine automatische Kompensation von Maßtoleranzen bei der SMD-Bestückung und SMD-Verlötung.

Dabei wird mit besonderem Vorteil ein Endabschnitt des Kontaktelements so gebogen, dass er etwa parallel zur Fluchtungsebene der zweiten Gehäuseseite verläuft. Eine solche Formgebung hat sich als günstig für die Bestückung und das Löten mittels SMD-Verfahren erwiesen.

Bei einer bevorzugten Weiterbildung des Verfahrens wird zuerst die Leiterplatte mittels einer Schablone mit Lötpaste bestrichen. Anschließend werden sämtliche elektronischen Bauelemente, einschließlich der Leistungs-Halbleiter, einseitig oder beidseitig auf der Oberfläche der Leiterplatte positioniert, wobei deren Kühlelement von der Leiterplatte weg zeigt. Schließlich durchläuft die Leiterplatte einen Wärmeofen, in dem durch Erwärmung der Lötpaste die Bauteile mit der Leiterplatte fest verlötet werden. Das mühsame Nachbestücken und Auflöten von Leistungs-Halbleitern im Anschluss an eine SMD-Bestückung der Leiterplatte kann somit entfallen. Das Bestückungsverfahren zeichnet sich insbesondere dadurch aus, dass durch die besondere Ausgestaltung der Kontaktfüße der verwendeten Leistungs-Halbleiter beim Positionieren derselben zugleich ein Ausgleich von Maßtoleranzen stattfindet, und dass eine einfache SMD-Bestückung möglich ist, was die Fertigungskosten entsprechend reduziert.

Weitere Einzelheiten und vorteilhafte Weiterbildungen der Erfindung ergeben sich aus den im folgenden beschriebenen und in der Zeichnung dargestellten Ausführungsbeispielen, sowie aus den übrigen Unteransprüchen. Es zeigt:
- Fig. 1: eine Draufsicht auf einen Leistungs-Halbleiter, welcher in erfindungsgemäßer Weise modifiziert ist,
- Fig. 2: eine Schnittansicht des Leistungs-Halbleiters, gesehen längs der Linie II-II der Fig. 1,
- Fig. 3: eine Draufsicht auf eine Leiterplatte, welche mit Leistungs-Halbleitern gemäß der vorliegenden Erfindung bestückt ist,
- Fig. 4: eine Schnittansicht der Leiterplatte entlang der Linie IV-IV der Fig. 3,
- Fig. 5: eine Schnittansicht durch eine Leiterplatte mit Leistungs-Halbleitern in Sandwichbauweise,
- Fig. 6: eine Schnittansicht durch eine Leiterplatte mit einem Leistungs-Halbleiter, einer Wärmeleitmatte und einem Gehäuse, und
- Fig. 7: eine Schnittansicht durch eine Leiterplatte mit Leistungs-Halbleitern in Sandwichbauweise, die zugehörigen Wärmeleitmatten und das Gehäuse.

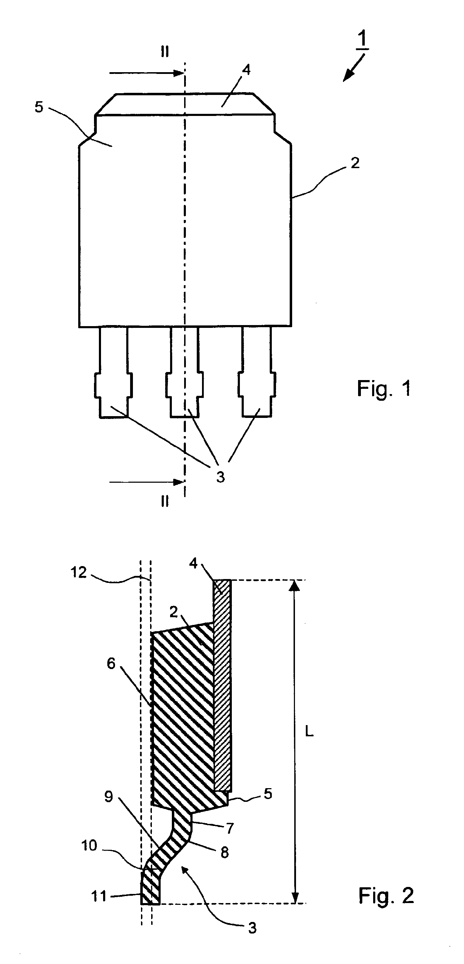

Fig. 1 zeigt einen Leistungs-Halbleiter 1 als eigenständiges Bauelement. Der Leistungs-Halbleiter 1, z.B. ein MOSFET (Feldeffekttransistor), hat ein Gehäuse 2 aus Kunststoff mit vier Anschlusskontakten. Dabei sind z.B. (von links nach rechts) der Gate-Anschluss, der Source-Anschluss und der erste Drain-Anschluss als Kontaktelemente zum Anschluss an eine Leiterplatte in Form von Kontaktfüßen 3 ausgebildet, die sich aus dem Gehäuse 2 heraus erstrecken. Ein zusätzlicher Anschluss, z.B. ein zweiter Drain-Anschluss 4 als vierter Anschlusskontakt befindet sich in Fig. 1 an der Oberseite 5 des Leistungs-Halbleiters 1. Der Anschluss 4 ist als Kühlkörper ausgebildet, der auf seiner Außenseite eine Kühlfläche hat.

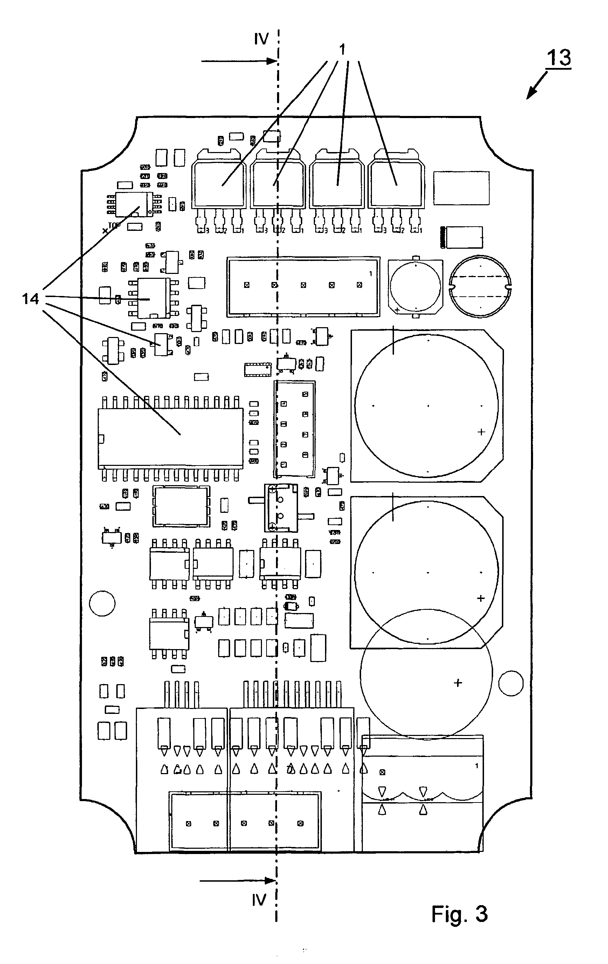

**Fig. 2** zeigt eine Schnittansicht des Leistungs-Halbleiters 1 entlang der Linie II-II der Fig. 1. Der zusätzliche Anschluss 4, z.B. hier der zweite Drain-Anschluss, ist an der von einer Leiterplatte 13 (Fig. 3) abgewandten Oberseite 5 des Leistungs-Halbleiters 1 angeordnet und als Kühlplatte ausgebildet. Diese ist im Gehäuse 2 des Leistungs-Halbleiters 1 integriert.

Die Kontaktfüße 3 erstrecken sich bei der erfindungsgemäßen Ausgestaltung stufen- bzw. absatzförmig in Richtung Unterseite 6 des Leistungs-Halbleiters 1, also in Richtung zu dessen "Kunststoffseite" 6, welche der Kühlplatte 4 gegenüber liegt. Jeder Kontaktfuß 3 umfasst bei dieser Ausgestaltung ein am Gehäuse 2 angebrachtes gerades Ansatzstück 7, das über eine erstes Bogenstück 8 in ein in Richtung Unterseite 6 abfallendes Schrägstück 9 übergeht. Das Schrägstück 9 geht anschließend in ein zweites Bogenstück 10 über und endet in einem geraden Auslaufstück 11. Letzteres verläuft dabei etwa parallel zum geraden Ansatzstück 7. Die Kontaktfüße 3 sind leicht über die Fluchtungsebene 12 der Kunststoffseite 6 des Leistungs-Halbleiters 1 hinaus gebogen, so dass sie von der Kühlplatte 4 weg zeigen. Scharfkantige Übergänge, die Risse oder Brüche hervorrufen könnten, werden durch die Krümmungen 8, 10 mit ihren relativ großen Radien und stumpfen Winkeln vermieden.

Die Länge L der Bauelemente 1 kann durch Kürzen der Kontaktfüße 3 bestimmt werden, nachdem diese absatzförmig gebogen worden sind. Das Bauelement 1 ist nach dem Biegen und Kürzen mechanisch sehr stabil und kann deshalb in einer automatischen SMD-Bestückungsanlage verarbeitet werden.

Die Biegung der Kontaktfüße erfolgt so weit, bis sie leicht über die Fluchtungsebene 12 der Kunststoffseite 6 hinaus ragen. Das hat den Vorteil, dass Fertigungs-, Bauteil- und Biegetoleranzen später beim SMD-Löten besser ausgeglichen werden können. Auch kann so erreicht werden, dass der Leistungs-Halbleiter 1 nicht mit der gesamten Gehäuseseite 6 auf der Leiterplatte 13 aufliegt.

**Fig. 3** zeigt die Leiterplatte 13 mit Leistungs-Halbleitern 1 und weiteren elektronischen Bauelementen 14.

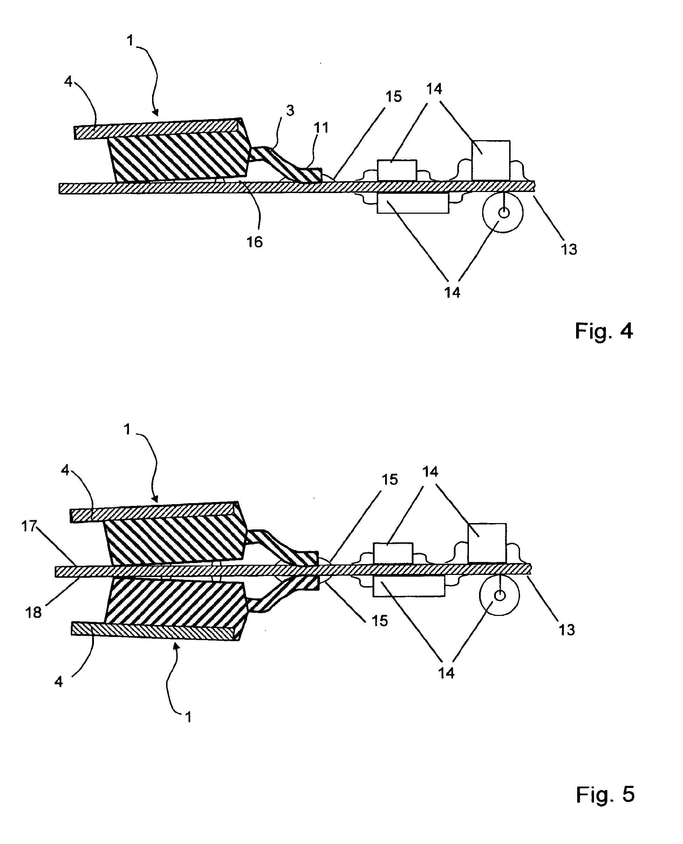

Eine Schnittansicht der Leiterplatte 13 entlang der Linie IV-IV der Fig. 3 ist in **Fig. 4** dargestellt. Darin ist beispielhaft ein auf der Leiterplatte 13 kontaktierter Leistungs-Halbleiter 1 dargestellt, der in der dargestellten Weise auf die Leiterplatte 13 aufgeklebt ist. Darüber hinaus sind auf der Leiterplatte 13 weitere elektronische Bauteile 14 dargestellt, die zum Leistungs-Halbleiter 1 benachbart angeordnet sind. Der Leistungs-Halbleiter 1 ist mit seinen Kontaktfüßen 3 über Lötpunkte 15 und per SMD-Löttechnik mit den entsprechenden Leiterbahnen (nicht dargestellt) der Leiterplatte 13 verbunden. Dazu liegen die Kontaktfüße 3 wie dargestellt mit ihrem Endabschnitt 11 gerade auf der Leiterplatte 13 auf. Da die Kontaktfüße 3 leicht über die Fluchtungsebene 12 der Unterseite 6 des Leistungs-Halbleiters 1 hinaus ragen, liegt der Leistungs-Halbleiter 1 bevorzugt nicht mit seiner gesamten Kunststoffseite 6 auf der Leiterplatte 13 auf. Vielmehr verläuft zwischen dieser und der Kunststoffseite 6 des Gehäuses 2 des Leistungs-Halbleiters 1 bevorzugt ein keilförmiger Luftspalt 16, der als zusätzlicher Wärmeisolator dient. Dies verhindert, dass die Verlustwärme des Leistungs-Halbleiters 1 die Leiterplatte 13 unnötig erwärmt.

**Fig. 5** zeigt ein weiteres Ausführungsbeispiel der Erfindung. Die Schnittansicht verdeutlicht, dass hier zwei Leistungs-Halbleiter 1 in Sandwichbauweise auf der Leiterplatte 13 angeordnet sind. Dies bedeutet, dass die Leistungs-Halbleiter 1 an gegenüberliegenden Seiten 17, 18 der Leiterplatte 13 angeordnet sind, wodurch die natürliche Konvektion auf der Vorderseite 17 und Rückseite 18 der Leiterplatte 13 genutzt werden kann. Hieraus resultiert eine zusätzliche, schnellere Kühlung der Leistungs-Halbleiter 1 und folglich eine Erhöhung der Lebensdauer der angrenzenden Bauteile 14.

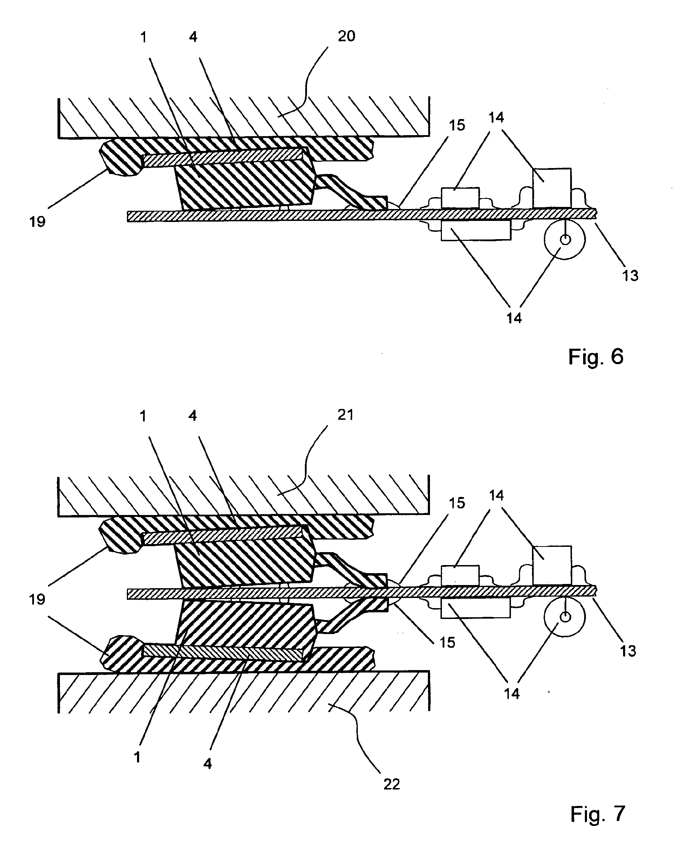

**Fig. 6** zeigt ein weiteres Ausführungsbeispiel der Erfindung. Abgebildet ist eine Schnittansicht durch eine Leiterplatte 13 mit einem erfindungsgemäßen Leistung-Halbleiter 1. Zusätzlich ist auf der integrierten Kühlplatte 4 des Leistungs-Halbleiters 1 eine Wärmeleitmatte 19 aufgebracht, die dem schnelleren Wärmeabfluss von der Kühlplatte 4 zu einem benachbarten Gehäuse 20 dient. Die Wärmeleitmatte 19 liegt dabei auf der Kühlplatte 4 eben und flächig auf und kann durch ihre Kompressibilität Maßtoleranzen zwischen Leistungs-Halbleiter 1 und Gehäuse 20 ausgleichen. Durch den Einsatz solcher Wärmeleitmatten 19 ergibt sich eine bessere Kühlung, die auch die Dauerleistung und Lebensdauer der angrenzenden Bauteile 14 erhöht. Diese Lösung eignet sich besonders für Fälle, wo die natürliche Konvektion nicht ausreichend ist, um die vom Leistungs-Halbleiter 1 erzeugte Wärme abzuführen. Durch den Einsatz der Wärmeleitmatte ergibt sich eine schnellere Kühlung, welche die Bauleistung der angrenzenden Bauteile 14 erhöht.

In **Fig. 7** ist ein weiteres Ausführungsbeispiel der Erfindung dargestellt. Die Schnittansicht zeigt wiederum eine Leiterplatte 13 mit zwei Leistungs-Halbleitern 1 in Sandwichbauweise. In diesem Fall sind ebenfalls Wärmeleitmatten 19 zur Ableitung der Wärme an Gehäuseteile oder Kühlkörper 21, 22 vorgesehen.

Bei der SMD-Bestückung wird die Leiterplatte 13 mittels einer (nicht dargestellten) Schablone mit Lötpaste 15 bestrichen. Danach werden in einer automatischen Bestückungsanlage die elektronischen Bauteile 14 und die Leistungs-Halbleiter 1 mit ihren SMD-gerecht gebogenen Anschlüssen 3 auf der Oberfläche der Leiterplatte 13 positioniert und festgeklebt, wobei die Kühlkörper 4 von der Leiterplatte 13 weg zeigen.

Anschließend durchläuft die bestückte Leiterplatte 13 einen Wärmeofen, in dem, durch Erwärmen der Lötpaste 15, die Bauteile 14 und die Leistungs-Halbleiter 1 fest mit der Leiterplatte 13 verlötet werden. Dadurch entfällt ein kostspieliges Einlöten der Leistungs-Halbleiter 1 von Hand. In Ausnahmefällen kann jedoch auch eine Nachbestückung von Hand erfolgen.

## Patentansprüche

1. Anordnung mit einer Leiterplatte (13) und einem auf dieser angeordneten Leistungs-Halbleiter (1), welcher ein Gehäuse (2) mit einer ersten Gehäuseseite (5) und einer dieser gegenüber liegenden zweiten Gehäuseseite (6) aufweist, von denen die erste Gehäuseseite (5) mit einem Kühlkörper (4) zur Ableitung von Verlustwärme versehen ist und die zweite Gehäuseseite (6) einen Teil einer Fluchtungsebene (12) bildet, welcher Leistungs-Halbleiter (1) ferner elektrische Anschlusselemente (3) aufweist, die aus dem Gehäuse (2) heraus ragen und in Richtung zur zweiten Gehäuseseite (6) so abgebogen sind, dass sie über deren Fluchtungsebene (12) hinaus ragen, und die an ihrem Endbereich (11) jeweils für eine SMD-Bestückung der Leiterplatte (13) ausgebildet sind,
mit den weiteren Merkmalen, dass der Leistungs-Halbleiter (1) in der Weise auf der Leiterplatte (13) angeordnet ist, dass seine zweite Gehäuseseite (6) der Leiterplatte (13) zugewandt ist, und die elektrischen Anschlusselemente (3) an ihrem Endbereich (11) in SMD-Technik mit der Leiterplatte (13) verlötet (15) sind, und dass auf dem von der Leiterplatte (13) abgewandten Kühlkörper (4) eine Wärmeleitmatte (19) zwischen diesem Kühlkörper (4) und einer Wärmesenke (20; 21, 22) angeordnet ist.

2. Anordnung nach Anspruch 1, bei welcher mindestens ein Anschlusselement (3), beginnend am Gehäuse (2), einen ersten Abschnitt (7) aufweist, der über einen Übergangsradius (8) in einen relativ zum ersten Abschnitt (7) schräg und in Richtung zur Fluchtungsebene (12) verlaufenden zweiten Abschnitt (9) übergeht, welcher seinerseits über einen Übergangsabschnitt (10) in einen geraden Endabschnitt (11) übergeht, der für die SMD-Bestückung geeignet ist.

3. Anordnung nach Anspruch 2, bei welcher der gerade Endabschnitt (11) im Wesentlichen parallel zum ersten Abschnitt (7) verläuft.

4. Anordnung nach einem der vorhergehenden Ansprüche, bei welcher die Anschlusselemente (3) so geformt sind, dass mindestens ein Teil der zweiten Gehäuseseite (6) durch einen Luftspalt (16) von der Leiterplatte (13) getrennt ist.

5. Anordnung nach Anspruch 4, bei welcher der Luftspalt (16) im Querschnitt einen etwa keilförmigen Verlauf hat.

6. Anordnung nach einem der vorhergehenden Ansprüche, bei welcher der Leistungs-Halbleiter (1) auf der Leiterplatte (13) aufgeklebt ist.

7. Anordnung nach einem der vorhergehenden Ansprüche, bei welcher auf der dem Halbleiter (1) gegenüber liegenden Seite der Leiterplatte (13) ein zweiter Leistungs-Halbleiter (1) in SMD-Technik befestigt ist.

8. Anordnung nach einem der vorhergehenden Ansprüche, bei welcher der mindestens eine Leistungs-Halbleiter als Leistungs-Feldeffekttransistor (1) ausgebildet ist.

9. Verfahren zur Herstellung einer mit einem Leistungs-Halbleiter (1) bestückten Leiterplatte (13), welcher Leistungs-Halbleiter (1) eine mit einer Kühlplatte (4) versehene erste Gehäuseseite (5) und eine dieser gegenüber liegende zweite Gehäuseseite (6) aufweist, welch letztere einen Teil einer Fluchtungsebene (12) bildet,
bei welchem Verfahren Kontaktelemente (3) des Leistungs-Halbleiters (1), welche aus dem Gehaüse (2) des Leistungs-Halbleiters (1) heraus vagen derart gebogen werden, dass sie die Fluchtungsebene (12) der zweiten Gehäuseseite (6) durchdringen,
bei welchem ferner eine Lötpaste (15) an mindestens einer vorgegebenen Stelle auf die Leiterplatte (13) aufgebracht wird,
der Leistungs-Halbleiter (1) so auf der Leiterplatte (13) positioniert wird, dass seine abgebogenen Kontaktelemente (3) mit der Lötpaste (15) in Verbindung stehen,
bei welchem ferner die Leiterplatte (13) zwecks Herstellen einer Lötverbindung erwärmt wird, um die abgebogenen Kontaktelemente (3) durch eine SMD-Verbindung mit der Leiterplatte (13) zu verbinden,
und bei welchem auf der von der Leiterplatte (13) abgewandten Seite der Kühlplatte (4) eine Wärmeleitmatte (19) zwischen dieser Kühlplatte (4) und einer Wärmesenke (20; 21, 22) angebracht wird.

10. Verfahren nach Anspruch 9, bei welchem ein Endabschnitt (11) des Kontaktelements (3) so gebogen wird, dass dieser etwa parallel zur Fluchtungsebene (12) der zweiten Gehäuseseite (6) verläuft.

11. Verfahren nach Anspruch 9 oder 10, bei welchem das Kontaktelement (3) nach dem Biegen auf eine vorgegebene Länge (L) gekürzt wird.

12. Verfahren nach einem der Ansprüche 9 bis 11, bei welchem beim Positionieren Maßtoleranzen des Leistungs-Halbleiters (1) ausgeglichen werden.

13. Verfahren nach einem der Ansprüche 9 bis 12, bei welchem die Verfahrensschritte automatisch ausgeführt werden.

## Claims

1. Arrangement with a circuit board (13) and a power semiconductor (1) arranged thereon, which semiconductor comprises a housing (2) with a first housing side (5) and a second housing side (6) lying opposite this, of which the first housing side (5) is provided with a cooling body (4) for conducting away dissipated heat and the second housing side (6) forms a part of an alignment plane (12), which power semiconductor (1) further comprises electrical connecting elements (3), which project from the housing (2) and are bent in the direction towards the second housing side (6) in such a manner that they project beyond its alignment plane (12), and which are formed at their terminal region (11) respectively for an SMD mounting of the circuit board (13), with the further features that the power semiconductor (1) is arranged on the circuit board (13) in the manner that its second housing side (6) is facing the circuit board (13), and the electrical connecting elements (3) are soldered (15) at their terminal region (11) in SMD technology to the circuit board (13), and that on the cooling body (4) facing away from the circuit board (13) a thermally conductive mat (19) is arranged between this cooling body (4) and a heat sink (20; 21, 22).

2. Arrangement according to claim 1, in which at least one connecting element (3), starting at the housing (2), comprises a first section (7), which passes over via a transition radius (8) into a second section (9), which runs obliquely relative to the first section (7) and in the direction towards the alignment plane (12), which second section for its part passes over via a transition section (10) into a straight terminal section (11), which is suitable for the SMD mounting.

3. Arrangement according to claim 2, in which the straight terminal section (11) runs substantially parallel to the first section (7).

4. Arrangement according to one of the preceding claims, in which the connecting elements (3) are formed such that at least a part of the second housing side (6) is separated from the circuit board (13) by an air gap (16).

5. Arrangement according to claim 4, in which the air gap (16) has a roughly wedge-shaped progression in cross section.

6. Arrangement according to one of the preceding claims, in which the power semiconductor (1) is glued onto the circuit board (13).

7. Arrangement according to one of the preceding claims, in which a second power semiconductor (1) is attached in SMD technology to the side of the circuit board (13) lying opposite the semiconductor (1).

8. Arrangement according to one of the preceding claims, in which the at least one power semiconductor is formed as a power field effect transistor (1).

9. Method for manufacturing a circuit board (13) equipped with a power semiconductor (1), which power semiconductor (1) comprises a first housing side (5) provided with a cooling plate (4) and a second housing side (6) lying opposite this, which latter forms a part of an alignment plane (12), in which method contact elements (3) of the power semiconductor (1), which project from the housing (2) of the power semiconductor (1), are bent in such a manner that they penetrate the alignment plane (12) of the second housing side (6),
in which furthermore a soldering paste (15) is applied to the circuit board (13) in at least one predetermined place,
the power semiconductor (1) is positioned on the circuit board (13) in such a manner that its bent contact elements (3) are in association with the soldering paste (15),
in which furthermore the circuit board (13) is heated to produce a soldered connection, in order to connect the bent contact elements (3) to the circuit board (13) by an SMD connection,
and in which on the side of the cooling plate (4) facing away from the circuit board (13) a thermally conductive mat (19) is fitted between this cooling plate (4) and a heat sink (20; 21, 22).

10. Method according to claim 9, in which a terminal section (11) of the contact element (3) is bent in such a manner that this runs roughly parallel to the alignment plane (12) of the second housing side (6).

11. Method according to claim 9 or 10, in which the contact element (3) is shortened to a predetermined length (L) following bending.

12. Method according to one of claims 9 to 11, in which upon positioning, dimensional tolerances of the power semiconductor (1) are equalised.

13. Method according to one of claims 9 to 12, in which the method steps are executed automatically.

## Revendications

1. Dispositif comprenant une carte de circuits imprimés (13) et un semi-conducteur de puissance (1) disposé sur celle-ci, lequel comporte un boîtier (2) avec un premier côté de boîtier (5) et un deuxième côté de boîtier (6) opposé au premier, dont le premier côté de boîtier (5) est doté d'un corps de refroidissement (4) pour évacuer la chaleur perdue et le deuxième côté de boîtier (6) forme une partie d'un plan d'alignement (12), lequel semi-conducteur de puissance (1) comporte en outre des éléments de connexion électrique (3) qui sortent du boîtier (2) et sont pliés en direction du deuxième côté de boîtier (6) de manière à dépasser de son plan d'alignement (12), et qui sont conçus dans leur zone terminale (11) pour un équipement CMS d'une carte de circuits imprimés (13),
**caractérisé en outre par le fait que** le semi-conducteur de puissance (1) est disposé sur la carte de circuits imprimés (13) de telle manière que son deuxième côté de boîtier (6) soit tourné vers la carte de circuits imprimés (13), et les éléments de connexion électrique (3) sont brasés dans leur zone terminale (11) en technique CMS avec la carte de circuits imprimés (13),
et qu'une nappe conductrice de chaleur (19) est disposée sur le corps de refroidissement (4) éloigné de la carte de circuits imprimés (13) entre ledit corps de refroidissement (4) et un dissipateur thermique (20 ; 21, 22).

2. Dispositif selon la revendication 1, dans lequel au moins un élément de connexion (3), commençant au boîtier (2), comporte une première partie (7) qui passe, par un rayon de transition (8), à une deuxième partie (9) inclinée par rapport à la première partie (7) et s'étendant en direction du plan d'alignement (12), laquelle deuxième partie (9) passe à son tour, par une partie de transition (10), à une partie terminale droite (11) qui est adaptée à un équipement CMS.

3. Dispositif selon la revendication 2, dans lequel la partie terminale droite (11) s'étend sensiblement parallèlement à la première partie (7).

4. Dispositif selon une des revendications précédentes, dans lequel les éléments de connexion (3) sont formés de manière qu'au moins une partie du deuxième côté de boîtier (6) soit séparée de la carte de circuits imprimés (13) par un espace d'air (16).

5. Dispositif selon la revendication 4, dans lequel l'espace d'air (16) a une extension approximativement en forme de coin en coupe transversale.

6. Dispositif selon une des revendications précédentes, dans lequel le semi-conducteur de puissance (1) est collé sur la carte de circuits imprimés (13).

7. Dispositif selon une des revendications précédentes, dans lequel un deuxième semi-conducteur de puissance (1) est fixé en technique CMS du côté de la carte de circuits imprimés (13) opposé au semi-conducteur (1).

8. Dispositif selon une des revendications précédentes, dans lequel ledit au moins un semi-conducteur de puissance est réalisé sous la forme d'un transistor de puissance à effet de champ (1).

9. Procédé de fabrication d'une carte de circuits imprimés (13) équipée d'un semi-conducteur de puissance (1), lequel semi-conducteur de puissance (1) comporte un premier côté de boîtier (5) doté d'une plaque de refroidissement (4) et un deuxième côté de boîtier (6) opposé au premier, lequel deuxième côté de boîtier (6) forme une partie d'un plan d'alignement (12),
dans lequel procédé des éléments de contact (3) du semi-conducteur de puissance (1) qui sortent du boîtier (2) du semi-conducteur de puissance sont pliés de manière à traverser le plan d'alignement (12) du deuxième côté de boîtier (6), dans lequel, en outre, une pâte à braser (15) est appliquée sur au moins une zone prédéfinie de la carte de circuits imprimés (13),
le semi-conducteur de puissance (1) est positionné sur la carte de circuits imprimés (13) de manière que ses éléments de contact pliés (3) soient en contact avec la pâte à braser (15),
dans lequel, en outre, la carte de circuits imprimés (13) est chauffée afin de réaliser une brasure pour relier les éléments de contact pliés (3) à la carte de circuits imprimés (13) par une liaison CMS,
et dans lequel une nappe conductrice de chaleur (19) est disposée sur le côté de la plaque de refroidissement (4) éloigné de la carte de circuits imprimés (13) entre ladite plaque de refroidissement (4) et un dissipateur thermique (20 ; 21, 22).

10. Procédé selon la revendication 9, dans lequel une partie terminale (11) de l'élément de contact (3) est pliée de manière à s'étendre approximativement parallèlement au plan d'alignement (12) du deuxième côté de boîtier (6).

11. Procédé selon la revendication 9 ou 10, dans lequel l'élément de contact (3) est raccourci à une longueur prédéfinie (L) après le pliage.

12. Procédé selon une des revendications 9 à 11, dans lequel des tolérances dimensionnelles du semi-conducteur de puissance (1) sont compensées lors du positionnement.

13. Procédé selon une des revendications 9 à 12, dans lequel les étapes du procédé sont exécutées automatiquement.
